# EUROPÄISCHE PATENTANMELDUNG

(11) **EP 3 597 389 A1**
(43) Veröffentlichungstag der Anmeldung: **22.01.2020**
(21) Anmeldenummer: 19171895.6
(22) Anmeldetag: 30.04.2019
(51) Int. Cl.: B29C 44/12, B29C 44/14, B29C 43/18, H01L 31/048, H02S 20/30, B62D 25/06, B29C 43/20, B29C 44/06, B61D 17/00, B32B 27/06, B32B 27/30, B32B 27/40, B32B 3/18, B60K 16/00, B60L 8/00, B29C 51/08, B29C 51/26

(54) **VERFAHREN ZUR HERSTELLUNG EINES FLÄCHENHAFTEN BAUELEMENTES MIT INTEGRIERTEN SOLARZELLEN UND BAUELEMENT MIT INTEGRIERTEN SOLARZELLEN**

(30) Priorität: 18.07.2018 DE 102018117337; 12.04.2019 DE 202019102123 U
(71) Anmelder: PARAT Beteiligungs GmbH, 94089 Neureichenau (DE)
(72) Erfinder: Atzinger, Philip, 94051 Hauzenberg (DE); Schmid, Tobias, 94089 Neureichenau (DE)
(74) Vertreter: Roche, von Westernhagen & Ehresmann

(57) **Zusammenfassung**

Die Erfindung betrifft u. a. ein Verfahren zur Herstellung eines flächenhaften Photovoltaik-Bauelementes (10) für Außenanwendungen, umfassend unter anderem die folgenden Schritte:
a) Bereitstellen einer tiefziehbaren Folie (10) aus einem transparenten Kunststoff,
b) Tiefziehen der Folie (11) in einem Werkzeug (34),
c) Anbringen einer Struktur (19), die Solarzellen (32) umfasst, an einer Innenseite (16) der tiefgezogenen Folie (12),
d) Anordnen der tiefgezogen Folie (12) mit angebrachter Struktur (19) in dem Innenraum (33) eines insbesondere wenigstens zwei Werkzeughälften (13, 14) umfassenden Werkzeuges (34),
e) Einbringen einer flüssigen Polyurethan-Vergussmasse (24) in den Innenraum (33) des Werkzeuges (34) und Verteilen der Polyurethan-Vergussmasse (24) entlang einer Innenseite (18) der Struktur (19) und/oder entlang der Innenseite (16) der Folie (12),
f) Aushärtenlassen der Polyurethan-Vergussmasse, insbesondere bei geschlossenem Werkzeug, unter Ausbildung einer Versteifungsschicht (30), oder umfassend anstelle der Schritte e) und f) die folgenden Schritte j) und k):
j) Einbringen einer granularen Partikelschaummasse in den Innenraum (33) des Werkzeuges (34) und Verteilen entlang einer Innenseite (18) der Struktur (19) und/oder entlang der Innenseite (16) der Folie (12),
k) Verbacken und Aushärtenlassen der Partikelschaummasse, insbesondere bei geschlossenem Werkzeug, unter Ausbildung einer Versteifungsschicht (30),

## Beschreibung

Die Erfindung betrifft zunächst ein Verfahren zur Herstellung eines flächenhaften Bauelementes für Außenanwendungen.

Derartige Herstellungsverfahren werden von der Anmelderin seit geraumer Zeit durchgeführt.

Als ein flächenhaftes Bauelement für Außenanwendungen im Sinne der vorliegenden Patentanmeldung werden solche Bauelemente bezeichnet, die eine beliebige Raumform aufweisen, und beispielsweise ebene Abschnitte und/oder im Raum gekrümmte Abschnitte aufweisen, und die eine Wandstärke, also eine Erstreckung in einer Z-Richtung aufweisen, die wesentlich geringer ist als die Erstreckung des Bauteils in X- und Y-Richtung. Die sich in Z-Richtung, also sich senkrecht zur X- und Y-Richtung erstreckende Wandstärke, beträgt bei derartigen flächenhaften Bauelementes etwa ein Fünftel bis ein Fünfhundertstel der Länge des Bauelementes in X-Richtung bzw. der Breite in Y-Richtung des Bauelementes.

Das erfindungsgemäß herzustellende Bauelement ist für Außenanwendungen vorgesehen: Dies bedeutet, dass das Bauelement bei bestimmungsgemäßem Gebrauch im Außenraum angeordnet oder positioniert wird.

Insbesondere können mit dem erfindungsgemäßen Verfahren Bauelemente hergestellt werden, die als Dachelement, als Seitenwandelement, als Motorhaube, als Kofferraumdeckel, als Kotflügel oder als Verkleidungsteil für ein Fahrzeug ausgebildet sind. Als Fahrzeuge kommen insbesondere PKWs, Nutzfahrzeuge, Caravane, Wohnwagen, Wohnmobile, Landmaschinen, Baumaschinen und Baufahrzeuge oder dergleichen Fahrzeuge in Betracht.

In dem Bereich der Fertigung derartiger Bauelemente besitzt die Anmelderin eine große Expertise. Insbesondere wird verwiesen auf die älteren Patentanmeldungen der Anmelderin unter den Aktenzeichen DE 10 2017 109 953 A1, DE 10 2016 112 290 A1; DE 10 2015 109 897 A1, DE 10 2013 018 694 A1, DE 10 2013 008 592 A1, DE 10 2013 005 523 A1, DE 10 2013 008 364 A1, DE 10 2015 111 052 A1, DE 10 2012 017 698 A1 und DE 10 2012 014 689 A1, deren Inhalt hiermit in den Inhalt der folgenden Patentanmeldung, auch zum Zwecke der Bezugnahme auf einzelne Merkmale, mit eingeschlossen wird.

Im Zuge der Umwälzungen in der Antriebstechnik von Fahrzeugen, nämlich der Abnahme der Anteile an Verbrennungsmotoren und der Zunahme der Anteile an Elektromotoren, gewinnt die Erzeugung elektrischer Energie an Bedeutung.

Es besteht daher der Bedarf, Teile von Fahrzeugen mit Solarzellen auszustatten, um - möglichst großflächig - Sonnenlicht bzw. elektromagnetische Strahlung von der Sonne einzufangen und in elektrische Energie umzuwandeln, um diese elektrische Energie entweder elektrischen Verbrauchern der Fahrzeuge zuzuführen oder die Energie in Akkumulatoren zwischenzuspeichern.

Dabei wird gemäß einer bekanntgewordenen Herangehensweise der Ansatz verfolgt, an einem bestehenden Fahrzeug nachträglich ein Solarzellenmodul anzubringen. Hiermit sind jedoch zahlreiche Nachteile verbunden.

Die Erfindung stellt sich die Aufgabe, ein an sich bekanntes Verfahren zur Herstellung eines flächenhaften Bauelementes derartig weiterzubilden, dass auf effiziente und prozesssicher zu fertigende Weise eine Integration von Solarzellen in das Bauelement gelingt.

Die Erfindung löst die Aufgabe mit den Merkmalen des Anspruches 1.

Das Prinzip der Erfindung besteht darin, zunächst eine tiefziehbare Folie in einem Werkzeug tiefzuziehen. In Folge des Tiefziehvorgangs erhält die tiefgezogene Folie eine Raumform, die der Raumform des zu fertigenden Bauelementes entspricht oder im Wesentlichen entspricht. Die Außenseite der tiefgezogenen Folie weist also nach dem Tiefziehvorgang eine Raumform auf, die der Raumform der Außenseite des zu fertigenden flächenhaften Bauelementes entspricht.

Die Folie besteht aus einem transparenten Kunststoff. Transparent bedeutet, dass die Folie zumindest für einen Spektralbereich der von der Sonne emittierten, elektromagnetischen Strahlung durchlässig ist.

Insbesondere kommen erfindungsgemäß Materialien, wie Polycarbonat oder PMMA, in Betracht. Der Tiefziehvorgang kann unter Zuhilfenahme eines Unterwerkzeuges und eines Oberwerkzeuges erfolgen. Alternativ kommen für die Durchführung des Tiefziehvorganges beispielsweise auch Blas-Form-Verfahren in Betracht, bei denen die tiefzuziehende Folie vor dem eigentlichen Tiefzieh-Blasvorgang erwärmt wird.

Die tiefziehbare Folie kann im Ausgangszustand beispielsweise eine Wandstärke zwischen 0,01 mm und 10 mm, vorzugsweise zwischen 0,5 mm und 3 mm aufweisen.

In einem zweiten Verfahrensschritt wird erfindungsgemäß nach dem Tiefziehen der Folie an der Innenseite der tiefgezogenen Folie eine Struktur angebracht, die Solarzellen umfasst. Die Innenseite der Folie und die Außenseite der Folie sowie die entsprechenden Innenseiten und Außenseiten der später noch zu beschreibenden Elemente und Schichten beziehen sich auf die Gebrauchsposition des fertig hergestellten Bauelementes: Die Außenseite des Bauelementes und dementsprechend die Außenseite der tiefgezogenen Folie ist im Gebrauchszustand des Bauelementes dem Außenraum, also z. B. der Sonne, hin zugewandt und die Innenseite ist beispielsweise dem Innenraum des Fahrzeuges oder dem Innenraum des Motorraumes des Fahrzeuges zugewandt.

Die an der Innenseite der tiefgezogenen Folie anzubringende Struktur kann eine oder mehrere Lagen oder Schichten oder Module aus oder mit Solarzellen umfassen, die in der Lage sind, von der Sonne emittierte elektromagnetische Strahlung in elektrische Energie umzuwandeln. Die Solarzellen können auch in eine Verbundstruktur eingebettet sein. Beispielsweise kann die Struktur Solarzellen umfassen, die in eine Matrix aus Kunststoff eingebettet sind oder von einer solchen Matrix vollständig oder teilweise umhüllt sind. Gemäß der Erfindung kommen insoweit auch zur Bereitstellung einer solchen Struktur Verbundkonstruktionen in Betracht, die aus Solarzellen und anderen Werkstoffen bestehen.

Die Struktur wird insbesondere als eine handhabbare Einheit bereitgestellt, die unmittelbar auf der Innenseite der tiefgezogenen Folie angebracht, z. B. daran festgeklebt werden kann. Von der Erfindung ist auch umfasst, wenn die Struktur ausschließlich aus Solarzellen besteht, die mit oder ohne Zwischenschaltung einer Klebeschicht auf die Innenseite der tiefgezogenen Folie aufgebracht werden, und durch eine Trägerschicht, z. B. eine Klebefolie, die die Solarzellen innenseitig überdeckt oder überfängt, auf die Innenseite der tiefgezogene Folie aufgeklebt wird.

Auch andere Anbringungsverfahren zur Anbringung von einer solchen Struktur an der Folie sind von der Erfindung umfasst.

Denkbar, und von der Erfindung ebenfalls umfasst, ist auch, wenn die Solarzellen unmittelbar auf die tiefgezogene Folie aufgebracht, beispielsweise durch Schichtwachstum, aufgebracht werden, oder epitaktisch oder durch Dampfabscheidung oder durch andere geeignete Verfahren aufgebracht werden.

Gemäß einer vorteilhaften Ausgestaltung der Erfindung ist vorgesehen, dass die die Solarzellen umfassende Struktur unter Durchführung eines Schrittes des Vakuumlaminierens auf die tiefgezogene Folie aufgebracht wird. Hierdurch kann insbesondere die Bildung von Luftblasen vermieden werden. Auch ermöglicht dieses Verfahren eine einfache und sichere rissfreie Anbringung der Struktur an der Folie.

Gemäß der Erfindung wird in einem weiteren Schritt vorgesehen, dass die tiefgezogene Folie mit daran angebrachter Struktur in dem Innenraum eines Werkzeuges angeordnet wird. Das Werkzeug weist vorzugsweise zwei Werkzeughälften, nämlich ein Unterwerkzeug und ein Oberwerkzeug auf.

Vorteilhafterweise wird die tiefgezogene Folie mit der angebrachten Struktur in dem Unterwerkzeug angeordnet.

Sodann wird in einem weiteren Verfahrensschritt gemäß einer Alternative der Erfindung in den Innenraum des Werkzeuges eine flüssige Polyurethan-Vergussmasse eingebracht. Diese Polyurethan-Vergussmasse wird entlang der Innenseite der Struktur bzw. entlang der Innenseite der Folie verteilt.

Für den Fall, dass die Innenseite der Folie vollflächig, d. h. vollständig, mit einer Struktur versehen ist, wird die flüssige Polyurethan-Vergussmasse nur entlang der Innenseite der Struktur verteilt.

Für den Fall, dass die Innenseite der Folie nur teilweise mit einer Struktur versehen ist, wird die Polyurethan-Vergussmasse entlang der Innenseite der Struktur und entlang der Innenseite der Folie verteilt. Eine Verteilung der Polyurethan-Vergussmasse kann entweder aktiv dadurch erfolgen, dass beispielsweise eine Ausbringungsvorrichtung, z. B. ein verfahrbarer Mischkopf, entlang der Innenseite der tiefgezogenen Folie verfährt und sukzessive flüssige Polyurethan-Vergussmasse abgibt, und insoweit eine Vorverteilung oder Verteilung erreicht. Von der Erfindung ist aber auch umfasst, wenn sich die Polyurethan-Vergussmasse aufgrund eines Fließvorganges selbstständig oder im Wesentlichen selbstständig entlang der Innenseite der Struktur oder der Innenseite der Folie verteilt.

Gemäß einem weiteren Verfahrensschritt der Erfindung erfolgt nun ein Aushärtenlassen der Polyurethan-Vergussmasse. Die Polyurethan-Vergussmasse wird insbesondere bei geschlossenem Werkzeug zum Aushärten gebracht. Dabei kann unter Einhaltung entsprechender Druckbereiche und vorzugsweise unter Einwirkung vorgegebener Temperaturen, z. B. durch Heizen des Werkzeuges, die Reaktionszeit der Polyurethan-Vergussmasse, die bis zu einem vollständigen oder nahezu vollständigen Aushärten erforderlich ist, exakt bestimmt werden, so dass die Zykluszeiten exakt vorherbestimmt und optimiert werden können. Die Polyurethan-Vergussmasse härtet unter Ausbildung einer Versteifungsschicht des Bauelementes aus. Nach dem Aushärtenlassen kann das auf diese Weise gefertigte Bauelement aus dem Werkzeug bzw. aus der Werkzeugform entnommen werden.

Das aus dem Werkzeug entnommene, gefertigte Bauelement kann selbstverständlich noch weiteren Bearbeitungsschritten unterworfen werden: So können beispielsweise Überstände, die in Folge des Tiefziehvorgangs oder in Folge des Ausschäumvorgangs entstehen, abgetrennt bzw. abgefräst werden. Auch Reinigungsschritte, Oberflächenbearbeitungsschritte oder Lackierschritte können vorgesehen werden.

Das mit dem erfindungsgemäßen Verfahren hergestellte Bauelement ist leichtbauend ausgebildet und aufgrund der vorgesehenen Verstärkungsschicht biegesteif. Die Struktur mit den Solarzellen ist - geschützt durch die Folie - geschützt untergebracht. Die außenseitig der Solarzelle angebrachte tiefgezogene Folie lässt das Licht durch, so dass die Effizienz der Solarzelle nicht beeinträchtigt wird. Die Oberflächeneigenschaft des zu fertigenden flächenhaften Bauelementes kann durch die Werkstoffeigenschaften der tiefziehbaren Folie bestimmt werden.

Die mechanischen Eigenschaften des flächenhaften Bauelementes werden von der ausgehärteten Verstärkungsschicht maßgeblich mitbeeinflusst.

Das erfindungsgemäß hergestellte Bauelement kann auf die gleiche oder nahezu gleiche Weise angewendet und eingesetzt werden, wie herkömmlich ausgebildete Bauelemente.

An dem Bauelement können beispielsweise auch Versteifungsstrukturen, wie Versteifungsrippen oder Versteifungszonen vorgesehen sein.

Auch Aufnahmen, beispielsweise für Schraubelemente, zur Anbringung von Scharnieren, Befestigungsmitteln oder dergleichen, können in das Bauelement mit integriert sein.

Gemäß einer Alternative der Erfindung wird anstelle der zuvor beschriebenen Schritte e) und f) des Anspruches 1, also anstelle des Einbringens einer flüssigen Polyurethan-Vergussmasse in das Werkzeug und eines Aushärtenlassens der Polyurethan-Vergussmasse, gemäß der Schritte j) und k) des Anspruches 1 folgendes unternommen:
Bei dem erfindungsgemäßen Verfahren gemäß dieser Alternative wird gemäß Schritt j) zunächst eine granulare Partikelschaummasse in den Innenraum des Werkzeuges eingebracht. Eine granulare Partikelschaummasse im Sinne der Erfindung ist ein granulares Ausgangsmaterial in Form von losen Partikeln. Die Partikel sind also nicht fest miteinander verbunden, insbesondere nicht miteinander verbacken. Infrage kommen aufschäumbare Partikelschäume wie EPS, EPE, oder PEEK oder andere geeignete Schäume.

Die granulare Partikelschaummasse kann beispielsweise in einem Ofen oder in einer Vorschäumeinrichtung, z. B. einem Infrarot-Backofen, teilweise aufgeschäumt sein, und in dem Werkzeug endaufgeschäumt werden. Von der Erfindung ist auch umfasst, wenn das granulare Ausgangsmaterial bereits endaufgeschäumt oder vollständig aufgeschäumt ist, und in dem Werkzeug lediglich verbacken wird. Weiter ist von der Erfindung umfasst, wenn das granulare Material der Partikelschaummasse vor- oder endaufgeschäumt in das Werkzeug eingebracht wird, und das Werkzeug überladen wird. Der Begriff eines überladenen Werkzeugs umfasst insbesondere Ausführungsbeispiele, bei denen das Volumen des in das Werkzeug eingebrachten Granulats, also der granularen Partikelschaummasse, das Volumen des Innenraums des Werkzeugs übersteigt. Hier findet also bei Durchführung des nachfolgenden Schrittes des Verbackens eine gewisse Komprimierung statt.

Gemäß Schritt j) der Alternative der Erfindung wird die granulare Partikelschaummasse entlang einer Innenseite der Struktur und/oder entlang der Innenseite der Folie verteilt. Eine solche Verteilung kann beispielsweise selbständig erfolgen, indem sich die beispielsweise in Form von Kugeln oder Kügelchen vorliegenden Granulatpartikel selbst entlang der Bodenfläche des Innenraums des Werkzeugs ausrichten. Alternativ erfolgt die Verteilung der Granulatpartikel automatisiert oder manuell, indem beispielsweise die Partikel glatt gestrichen werden. Auch kann im Zuge des Schließens des Werkzeugs mittels einer geeigneten Einrichtung, beispielsweise durch entsprechende Steuer- oder Führungsflächen oder auch durch eine Gebläseeinrichtung oder andere Apparate zur Erzeugung von Luftströmungen, für eine gleichmäßige Verteilung der Granulatpartikel gesorgt werden. Auch kann die granulare Partikelschaummasse nach dem Einbringen in den Innenraum des Werkzeugs unter Zuhilfenahme einer Vorrichtung, die die granulare Partikelschaummasse austrägt, und die relativ zu dem Werkzeug verlagerbar, insbesondere entlang einer XY-Ebene entlang verlagerbar ist, verteilt oder vorverteilt werden.

Gemäß dieser Alternative der Erfindung wird in einem Schritt k) die granulare Partikelschaummasse verbacken, die sodann aushärtet. Der Schritt des Verbackens erfolgt insbesondere unter Temperatureinfluss. Das Werkzeug ist hierzu vorteilhafterweise geheizt. Dabei kann das Werkzeug auch einer Temperaturwechselbeanspruchung ausgesetzt sein, so dass zunächst die für ein Verbacken der granularen Partikelschaummasse erforderliche Temperatur, von z. B. 80°C oder 160°C erreicht wird, und nachfolgend eine Temperaturänderung des Werkzeuges erfolgt, um eine Temperatur unterhalb des Schmelzpunktes der verbackenen Partikelschaummasse zu erreichen.

Der Schritt des Verbackens und Aushärtenlassens der Partikelschaummasse erfolgt vorteilhafterweise bei geschlossenem Werkzeug. Hierdurch kann insbesondere gegen einen Schaumdruck - falls die granulare Partikelschaummasse noch endausschäumt - der Schaum gehalten werden. Hierdurch kann eine besonders homogene Ausbildung der Versteifungsschicht erreicht werden.

Nach dem Aushärtenlassen stellt die Partikelschaummasse eine Versteifungsschicht bereit.

Als geeignete expandierbare Partikelschäume kommen beispielsweise Partikelschäume aus EPS, EPE und EPP infrage. Es handelt sich hier um Partikelschäume, die im voll oder endfertig ausgeschäumten und ausgehärteten Zustand Dichten im Bereich von typischerweise 15 kg/m3 bis 80 kg/m3 aufweisen können.

Das erfindungsgemäße Verfahren sieht vor, dass granulares Ausgangsmaterial in Form von losen Partikeln eines aufschäumbaren Partikelschaums bereitgestellt wird. Infrage kommen also solche Materialien, die als expandierbare Partikelschäume bekannt sind. Insbesondere versteht man hierunter expandierbare Partikelschäume aus EPS, EPE, oder EPP, oder auch expandierbares PEEK. Eine weitere Definition erfolgt weiter unten.

Das granulare Ausgangsmaterial kann in der verwendeten Form von kleinen Kügelchen oder Perlen, oder in Form von granularen Partikeln anderer regelmäßiger oder auch unregelmäßiger Form und Geometrie bereitgestellt werden. Das Ausgangsmaterial ist insbesondere schüttbar.

Die Partikel sind in dem granularen Ausgangsmaterial lose vorhanden, d. h. insbesondere noch nicht fest miteinander verbunden.

Gemäß einer Variante der Erfindung erfolgt zunächst der Schritt eines teilweisen Aufschäumens der Partikel. Das teilweise Aufschäumen bedeutet, dass die Partikel noch nicht vollständig aufgeschäumt werden. Beispielsweise kann gemäß der Erfindung vorgesehen sein, dass bezogen auf einen Aufschäum- oder Expansionsvorgang von 0 bis 100% ausgehend vom Volumen der Partikel des Ausgangsmaterials bis zu dem Volumen der Partikel im endfertig geschäumten Zustand, ein teilweises Aufschäumen zwischen 30 und 95% stattfindet. Der Begriff teilweises Aufschäumen umfasst insbesondere Ausführungsbeispiele der Erfindung, bei denen zumindest der Schritt eines zusätzlichen Aufschäumens der Partikel noch durchgeführt werden kann, hin zu einem endaufgeschäumten Zustand der Partikel.

Der Schritt des teilweisen Aufschäumens erfolgt insbesondere - aber nicht zwingend - an einem Ort, der sich entfernt von dem Unterwerkzeug befindet, in dem das Substrat angeordnet ist. Weiter vorteilhafterweise kann das teilweise Aufschäumen der Partikel in einem Ofen, insbesondere in einem Infrarot-Backofen, durchgeführt werden.

Gemäß einem weiteren Schritt dieser Variante des erfindungsgemäßen Verfahrens kann vorgesehen werden, dass die teilweise aufgeschäumten Partikel in das Unterwerkzeug verbracht werden. Der Transport der teilweise aufgeschäumten Partikel kann beispielsweise zeitlich unmittelbar nach der Durchführung des Schrittes des teilweisen Aufschäumens der Partikel durchgeführt werden. Er kann aber auch zeitlich deutlich später nach Durchführung des Schrittes des teilweisen Aufschäumens der Partikel durchgeführt werden.

Ein Verbringen und/oder ein Anordnen oder Positionieren der teilweise aufgeschäumten Partikel in das Unterwerkzeug kann maschinell, automatisiert, oder händisch erfolgen.

Gemäß dieser Variante der Erfindung wird nun das Werkzeug insbesondere geschlossen. Hierzu kann beispielsweise ein Oberwerkzeug gegen das Unterwerkzeug fahren und einen Aufnahmeraum oder Unterbringungsraum für die teilweise aufgeschäumten Partikel - sowie für die in dem Unterwerkzeug befindliche Folie - verschließen.

Gemäß der Erfindung wird des weiteren das Werkzeug geheizt. Von der Erfindung ist auch umfasst, wenn das Werkzeug ständig bei einer konstanten Temperatur oder bei einer Temperatur innerhalb eines vorgegebenen Temperaturbereichs gehalten wird.

Gemäß der Erfindung erfolgt sodann ein Endaufschäumen der zuvor bereits teilweise aufgeschäumten Partikel zu einem vollständig aufgeschäumten Partikelschaum. Die Partikel dehnen sich nun auf ihren maximalen Umfang bzw. auf ihr maximales Volumen aus, und verbacken oder versintern sozusagen miteinander. Dabei verbindet sich die Partikelschaummasse zugleich mit dem Substrat. Die Aktivierung des Rest- Aufschäumvorgangs erfolgt über die Werkzeugtemperatur. Von der Erfindung ist auch umfasst, wenn zusätzlich oder alternativ andere Aktivierungsmittel zur Aktivierung und zur Durchführung des Rest-Aufschäumvorgangs der Partikel, also für den Aufschäumvorgang der bereits teilweise aufgeschäumten Partikel bis hin zu einem endaufgeschäumten Zustand der Partikel, verwendet werden.

Gemäß der Erfindung erfolgt sodann ein Aushärtenlassen der Partikelschaummasse. Infolge dieses Aushärtevorgangs geht die Partikelschaummasse mit der Folie, also mit dem Substrat, eine dauerhafte feste Verbindung ein.

Von der Erfindung ist auch umfasst, wenn die Folie auf ihrer der Partikelschaummasse zugewandten Innenseite vor dem Verbringen der teilweise aufgeschäumten Partikel in das Unterwerkzeug mit einer entsprechenden Chemikalie, z. B. nach Art eines Haftgrundes, versehen wird, um die Verbindung zwischen der Folie und der Partikelschaummasse bzw. das Eingehen der Verbindung zwischen der Folie und der Partikelschaummasse zu optimieren.

Nach dem Aushärtenlassen der Partikelschaummasse kann das Werkzeug geöffnet und der so gebildete Formling entnommen werden. Der so gebildete Formling stellt das erfindungsgemäß zu fertigende Bauelement dar, oder kann durch nachfolgende Bearbeitungsschritte zu einem solchen Bauelement heranreifen.

### Definition expandierbarer Partikelschaum:

Als expandierbare Partikelschäume im Sinne der vorliegenden Patentanmeldung werden beispielsweise folgende Materialien angesehen:
Unter der Abkürzung EPS wird expandierbares Polystyrol bezeichnet. Dieses ist beispielsweise unter der Markenbezeichnung Styropor bekannt, und kann z. B. von der Firma Metz EPS-Hartschaumzuschnitte in 74376 Gemmrigheim bezogen werden.

Als Partikelschaum im Sinne der vorliegenden Patentanmeldung werden auch expandierbare Polyethylene (EPE) angesehen. Schließlich werden auch expandierbare Polypropylene (EPP) für die erfindungsgemäßen Zwecke als gut geeignet angesehen.

Insbesondere sind von dem Begriff Partikelschaum im Sinne der vorliegenden Patentanmeldung thermoplastische Partikelschäume umfasst. Diese können als Ausgangsmaterial Granulat, insbesondere auch Microgranulat, beispielsweise mit Durchmessern der Partikel in der Größenordnung von zwischen 0,1 und 5 mm aufweisen, weiter vorzugsweise Partikel mit einem Durchmesser von ca. 1 mm.

In den granularen Ausgangsmaterial-Partikeln des Partikelschaums sind vorzugsweise Treibmittel angeordnet. Diese können thermisch und/oder durch Chemikalien, beispielsweise auch durch Einwirkung von Wasserdampf, aktiviert werden, um den Vorschäumprozess auszulösen.

Der Vorgang des Restaufschäumens, also des Endaufschäumens bereits vorgeschäumter Partikel hin zu endaufgeschäumten Partikeln, wird im Sinne der vorliegenden Patentanmeldung auch als Versintern bezeichnet.

Als Treibmittel kommt für Polystyrol-Partikelschaum-Partikel beispielsweise Pentan in Betracht, das in die granularen Partikel einpolymerisiert ist. Sobald die Partikel Temperaturen von über 100° ausgesetzt werden, kann das Treibmittel verdampfen und bläht dabei das thermoplastische Grundmaterial zu Polystyrol-Schaumpartikeln auf.

Die zweite Aufschäumstufe kann erfindungsgemäß im Unterwerkzeug erfolgen, wobei die Werkzeugtemperatur so gewählt wird, dass das Treibmittel endausdampfen kann, und die Partikel endausschäumen können.

Neben EPS (extrudierbares Polystyrol) kommt für die Erfindung auch XPS in Betracht.

Als Bezugsquelle für expandierbares Polypropylen EPP bzw. XPS kommt beispielsweise die Firma Schaumaplast GmbH & Co. KG in 68799 Reilingen in Betracht.

Partikelschäume für den Einsatz bei dem erfindungsgemäßen Herstellungsverfahren können auch von expandierbaren Co-Polymeren bereitgestellt werden. Derartige Materialien sind beispielsweise unter dem Handelsnamen Grupor von dem Kunststoffwerk Katzbach GmbH & Co. KG in 93413 Cham beziehbar.

Als Ausgangsmaterial des im Rahmen der Erfindung einsetzbaren Partikelschaums kommt auch expandierbares PEEK (Polyetheretherketon) in Betracht. Dieses ist beispielsweise unter den Handelsnamen Gatone oder Victrex beziehbar.

Von der Erfindung sind neben den zuletzt beschriebenen granularen Partikelschaummassen, die zunächst voraufgeschäumt und später endaufgeschäumt werden, gleichermaßen auch Materialien umfasst, die als granulare Partikelschaummasse in bereits endausgeschäumtem Zustand vorliegen, und die im Werkzeug nur noch verbacken, also gesintert werden.

Gemäß einer vorteilhaften Ausgestaltung der Erfindung besteht die Folie aus Polycarbonat oder PMMA. Dies erlaubt einen Rückgriff auf herkömmliche Materialien und daraus resultierende Erfahrungswerte.

Gemäß einer weiteren vorteilhaften Ausgestaltung der Erfindung, die Schritt e) umfasst, umfasst die Polyurethan-Vergussmasse Verstärkungsfasern. Die Verstärkungsfasern können insbesondere Kurzfasern oder Langfasern umfassen. Verstärkungsfasern können beispielsweise aus Carbon, Aramid, Glas oder anderem Material hergestellt sein.

Gemäß einer weiteren vorteilhaften Ausgestaltung der Erfindung ist die Struktur auf die Innenseite der tiefgezogenen Folie aufklebbar. Hierdurch wird eine vorteilhafte und einfache Herstellung möglich. Es besteht die Möglichkeit, dass die Struktur eine Handhabungseinheit bereitstellt, die z. B. als Ganzes, in einfacher Weise, auf die Innenseite der tiefgezogenen Folie aufklebbar ist.

Gemäß einer weiteren vorteilhaften Ausgestaltung der Erfindung wird vor Schritt e) oder vor Schritt j) der folgende Schritt h) durchgeführt:
Einbringen einer flüssigen Barriereschicht-Vergussmasse, insbesondere aus Polyurethan, in den Innenraum des Werkzeuges und Verteilen der Barriereschicht-Vergussmasse entlang einer Innenseite der Struktur und/oder entlang der Innenseite der Folie.

Gemäß dieser Ausführungsform der Erfindung wird auf die mit der Struktur versehene tiefgezogene Folie innenseitig zunächst eine Barriereschicht-Vergussmasse aufgebracht. Diese kann wiederum bei geschlossenem Werkzeug oder alternativ bei offenem Werkzeug aushärten.

Vorteilhaft ist in diesem Zusammenhang insbesondere, wenn nachfolgend des Schrittes h) der Schritt e) des Einbringens einer flüssigen Polyurethan-Vergussmasse oder der Schritt j) des Einbringens einer granularen Partikelschaummasse zur Bereitstellung einer Versteifungsschicht erst erfolgt, wenn die Barriereschicht-Vergussmasse ausgehärtet ist. Durch das Aushärtenlassen der Barriereschicht-Vergussmasse kann erreicht werden, dass sich Strukturen, wie beispielsweise Gewebematten, Verstärkungsfasern oder dergleichen, in der Versteifungsschicht nicht abzeichnen.

Gemäß einer weiteren vorteilhaften Ausgestaltung der Erfindung wird vor Schritt e) der folgende Schritt i) durchgeführt:
Einbringen einer flüssigen in-mould-paint-Vergussmasse in den Innenraum des Werkzeuges und Verteilen der in-mould-paint-Vergussmasse entlang einer Innenseite der Struktur und/oder entlang der Innenseite der Folie.

In diesem Schritt wird vor dem Einbringen der flüssigen Polyurethan-Vergussmasse bzw. vor dem Einbringen der granularen Partikelschaumasse eine in-mould-paint-Vergussmasse innenseitig auf der tiefgezogenen Folie und der Struktur aufgebracht. Es handelt sich hierbei um einen Farb- oder Lackierauftrag, der für die Farbgebung des Bauelementes insgesamt maßgeblich ist. In diesem Zusammenhang wird angemerkt, dass auch die Solarzellen transparent ausgebildet sein können, mithin die Farbgebung des Bauelementes durch diese in-mould-paint-Vergussmasse maßgelblich bestimmt oder mitbestimmt wird.

Weiter vorzugsweise ist vorgesehen, dass nachfolgend des Schrittes i) entweder unmittelbar der Schritt e) oder unmittelbar der Schritt j) erfolgt, oder zuvor noch zusätzlich der Schritt h) erfolgt. Weiterhin vorteilhaft ist vorgesehen, dass nach dem Schritt i) und vor Durchführung der Schritte h) und/oder e) oder j) zunächst vorgesehen ist, dass abgewartet wird, bis die in-mould-paint-Vergussmasse ausgehärtet ist.

Gemäß einer weiteren vorteilhaften Ausgestaltung der Erfindung erfolgt der Tiefziehvorgang gemäß Schritt b) in einem ersten Werkzeug und das Anordnen der tiefgezogenen Folie mit angebrachter Struktur und das Einbringen der Polyurethan-Vergussmasse sowie das Aushärtenlassen der Polyurethan-Vergussmasse gemäß den Schritten d) bis f) oder das Einbringen der granularen Partikelschaummasse und deren Verbacken in einem zweiten Werkzeug. Dabei kann als Variante vorgesehen sein, dass das erste Werkzeug und das zweite Werkzeug von demselben Werkzeug bereitgestellt sind. Gemäß einer Alternative kann vorgesehen sein, dass das erste Werkzeug und das zweite Werkzeug von zwei unterschiedlichen Werkzeugen bereitgestellt sind. Im letzteren Fall ist erfindungsgemäß vorgesehen, dass die tiefgezogene Folie mit daran angebrachter Struktur nach Durchführung des Schrittes b) von dem ersten Werkzeug in das zweite Werkzeug verbracht wird.

Gemäß einer weiteren vorteilhaften Ausgestaltung der Erfindung sind elektrische Leitungen vorgesehen, die an die Struktur angeschlossen sind. Elektrische Leitungen dienen dazu, die Solarzellen mit einem Akkumulator, oder mit einem elektrischen oder elektronischen Bauelement oder unmittelbar mit einem elektrischen Verbraucher zu verbinden.

Dabei ist vorteilhaft vorgesehen, dass zumindest ein Abschnitt der Leitungen durch die Versteifungsschicht hindurch verläuft.

Hierzu kann beispielsweise in der Versteifungsschicht ein Durchtrittskanal für die elektrischen Leitungen vorgesehen sein. Dies ermöglicht eine Platzierung eines Anschlusses für die elektrischen Leitungen auf der Innenseite des gefertigten Bauelementes. Hierzu können beispielsweise Kontakte, Stecker, Buchsen oder andere, gegebenenfalls auch genormte, Anschlusselemente vorgesehen sein. Beispielsweise können in der Versteifungsschicht entsprechende Anschlussbuchsen angeordnet sein, wobei in der Versteifungsschicht entsprechende Aufnahmeräume oder Aufnahmefächer für Anschlusselemente, insbesondere für Kontakte oder Steckverbinder, vorgesehen sein können.

Gemäß einer weiteren vorteilhaften Ausgestaltung der Erfindung verläuft zumindest ein Abschnitt der Leitungen durch die Folie hindurch. Hierdurch kann - bei Bedarf - ein Anschluss an die elektrischen Leitungen auf der Außenseite des Bauelementes erfolgen, beispielsweise im Bereich von Anbauteilen, wie Scharnieren oder anderen Anbauteilen, vorzugsweise in einem Randbereich des Bauelementes.

Gemäß einer weiteren vorteilhaften Ausgestaltung der Erfindung weist die Folie einen Durchtrittskanal für die elektrischen Leitungen auf.

Gemäß einer weiteren vorteilhaften Ausgestaltung der Erfindung ist das Bauelement als ein Exterieur-Bauelement für ein Fahrzeug, wie PKW, Nutzfahrzeug, Caravan, Landmaschine od. dgl., ausgebildet, und bildet ein Dachelement, ein Seitenwandelement, eine Motorhaube, einen Kofferraumdeckel, einen Kotflügel oder ein Verkleidungsteil für dieses Fahrzeug aus.

Gemäß einer vorteilhaften Ausführungsform der Erfindungen ist vorgesehen, dass die Barriereschicht-Vergussmasse von einem Polyurethan, insbesondere von einem aromatischen Polyurethan bereitgestellt ist, wobei insbesondere Verstärkungsstoffe, weiter insbesondere mineralische Verstärkungsstoffe, wie Talkum oder Kreide zugesetzt sind.

Die Erfindung betrifft gemäß einem weiteren Aspekt ein Bauelement nach Anspruch 14.

Der Erfindung liegt die Aufgabe zugrunde, ein Bauelement bereitzustellen, welches einfach herstellbar ist und Solarzellen funktionssicher und herstellungsprozesssicher in das Bauelement integriert.

Die Erfindung löst die Aufgabe mit den Merkmalen des Anspruches 14.

Zur Vermeidung von Wiederholungen wird darauf hingewiesen, dass die bezüglich der obigen Ausführungen zu den Ansprüchen 1 bis 15 vorgebrachten Argumente und Ausführungen, zu den Merkmalen und deren Erläuterungen gleichermaßen auch für das Bauelement nach Anspruch 14 gelten.

Gleichermaßen wird darauf hingewiesen, dass ein Bauelement nach Anspruch 14 eines oder mehrere oder sämtliche Merkmale oder Merkmalskombinationen der zuvor, im Zusammenhang mit dem Herstellungsweg beschriebenen Art, aufweisen kann.

Weitere Vorteile der Erfindung ergeben sich aus den nicht zitierten Unteransprüchen sowie anhand der nachfolgenden Beschreibung der in den Zeichnungen dargestellten Ausführungsbeispiele. Darin zeigen:
- Fig. 1: schematisch, in einer teilgeschnittenen Ansicht, eine tiefziehbare Folie vor dem Tiefziehvorgang,
- Fig. 2: in einer teilgeschnittenen schematischen Darstellung ein Werkzeug mit Unterwerkzeug und Oberwerkzeug und der in dem Werkzeug tiefgezogenen Folie der Fig. 1, wobei das Werkzeug geöffnet dargestellt ist, und die tiefgezogene Folie von dem Unterwerkzeug geringfügig beabstandet dargestellt ist,
- Fig. 3: die tiefgezogene Folie aus Fig. 2 in Einzeldarstellung mit daran innenseitig angebrachter Struktur mit Solarzellen,
- Fig. 4: die tiefgezogene Folie mit daran angebrachter Struktur in einem geöffneten Werkzeug, umfassend ein Unterwerkzeug und ein Oberwerkzeug, wobei schematisch dargestellt im Innenraum des geöffneten Werkzeugs ein Mischkopf verfahren wird, der eine flüssige Polyurethan-Vergussmasse abgibt und auf der Innenseite der tiefgezogenen Folie und auf der Innenseite der Struktur verteilt,
- Fig. 5: das fertig hergestellte, noch in der geschlossenen Werkzeugform befindliche Bauelement nach dem Aushärten der Vergussmasse,
- Fig. 6: in einer teilgeschnittenen, schematischen, vergrößerten Detailansicht etwa gemäß Teilkreis VI in Fig. 5 einen Verbindungsbereich von tiefgezogener Folie, Solarzelle und Versteifungsschicht,
- Fig. 7: in Einzeldarstellung das fertig hergestellte und aus der Werkzeugform entnommene Bauelement,
- Fig. 8: in einer Darstellung gemäß Fig. 7 ein weiteres Ausführungsbeispiel eines erfindungsgemäßen Bauelementes mit an der Struktur angeschlossener elektrischer Zuleitung,
- Fig. 9a: in einer vergrößerten Detailansicht, etwa gemäß Teilkreis IX in Fig. 8, einen Anbindungsbereich der elektrischen Zuleitungen an die Solarzellen und den Durchgangskanal in der Versteifungsschicht,
- Fig. 9b: ein weiteres Ausführungsbeispiel eines erfindungsgemäßen Bauelementes in einer Darstellung analog zu Fig. 9a, wobei bei diesem Ausführungsbeispiel ein Kanal für den Durchtritt elektrischer Leitungen zu den Solarzellen in der tiefgezogenen Folie vorgesehen ist,
- Fig. 10: in einer vergrößerten Detaildarstellung gemäß Teilkreis X in Fig. 7 den Schichtaufbau eines erfindungsgemäß hergestellten Bauelementes,
- Fig. 11: in einer Darstellung gemäß Fig. 10 den Schichtaufbau eines weiteren Ausführungsbeispiels des erfindungsgemäßen Bauelementes,
- Fig. 12a: in einer Darstellung gemäß Fig. 10 den Schichtaufbau eines weiteren Ausführungsbeispiels des erfindungsgemäßen Bauelementes,
- Fig. 12b: in einer Darstellung gemäß Fig. 10 ein weiteres Ausführungsbeispiel, bei dem der Schichtaufbau des Bauelementes eine in-mould-paint-Vergussmasse und eine Barriereschicht-Vergussmasse aufweist,
- Fig. 13: in einer Darstellung gemäß Fig. 10 den Schichtaufbau eines weiteren Ausführungsbeispiels eines erfindungsgemäßen Bauelementes,
- Fig. 14: in einer vereinfachten, schematischen Darstellung ein Behältnis, in das eine unaufgeschäumte granulare Partikelschaummasse eingefüllt wird,
- Fig. 15: in einer schematischen Darstellung ähnlich Fig. 14 das Behältnis und zusätzlich eine schematisch dargestellte Aufschäumeinrichtung, insbesondere in Form eines Infrarot-Ofens, wobei die unaufgeschäumten Granulatpartikel der Fig. 14 teilweise aufgeschäumt oder endaufgeschäumt ausgebildet sind und gegenüber der Darstellung der Fig. 14 ihr Volumen erheblich vergrößert haben,

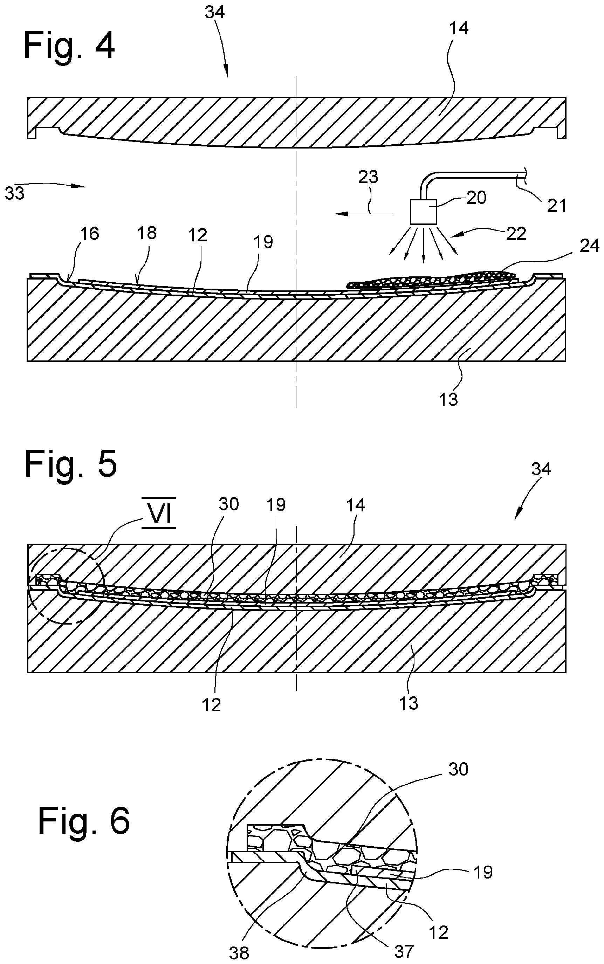

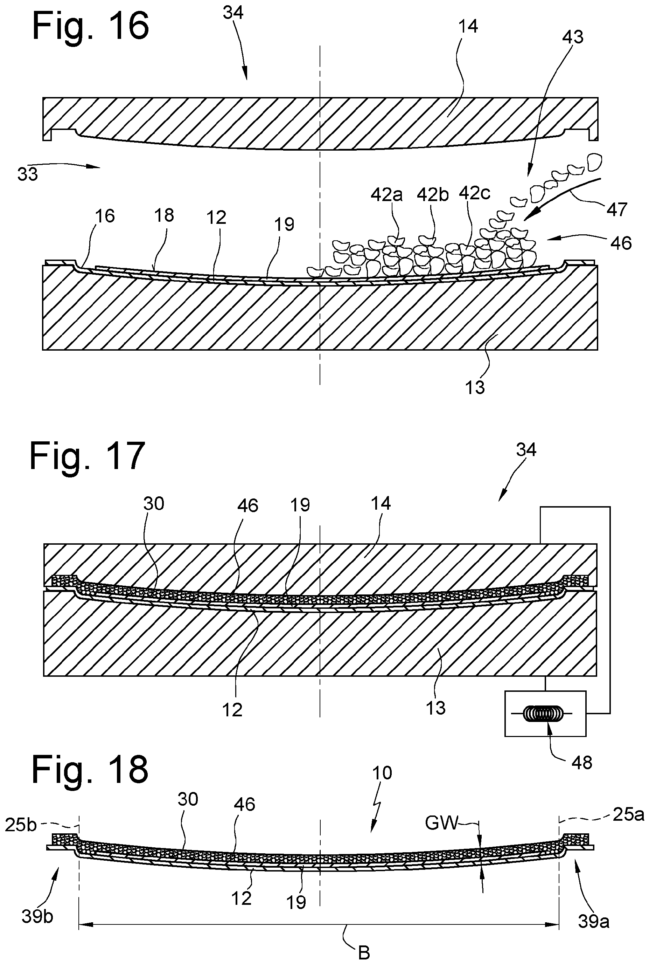

- Fig. 16: ein weiteres Ausführungsbeispiel der Erfindung in einer Darstellung gemäß Fig. 4, wobei die anhand der vorherigen Ausführungsbeispiele bereits beschriebene tiefgezogene Folie mit daran angebrachter Struktur in einem geöffneten Werkzeug angeordnet ist, und in das Unterwerkzeug eingelegt ist, wobei das Werkzeug geöffnet ist, und das Oberwerkzeug von dem Unterwerkzeug beabstandet ist, und wobei eine granulare Partikelschaummasse, die aus aufgeschäumten Partikeln besteht, in den Innenraum des Werkzeugs eingebracht wird, und entlang der Innenseite der tiefgezogenen Folie sowie entlang der Innenseite der Struktur verteilt wird,
- Fig. 17: das Ausführungsbeispiel der Fig. 16 in einer Darstellung gemäß Fig. 5, wobei das fertig hergestellte, noch in der geschlossenen Werkzeugform befindliche Bauelement nach dem Aushärten der granularen Partikelschaummasse dargestellt ist, wobei zur Erläuterung zusätzlich gegenüber der Darstellung der Fig. 5 eine Heizung angedeutet ist, die das Werkzeug temperiert, und
- Fig. 18: in einer Darstellung gemäß Fig. 7 das fertig hergestellte und aus der Werkzeugform entnommene Bauelement der Fig. 17 in Einzeldarstellung.

Ausführungsbeispiele der Erfindung sind in der nachfolgenden Figurenbeschreibung, auch unter Bezugnahme auf die Zeichnungen, beispielhaft beschrieben. Dabei werden der Übersichtlichkeit halber - auch soweit unterschiedliche Ausführungsbespiele betroffen sind - gleiche oder vergleichbare Teile oder Elemente oder Bereiche mit gleichen Bezugszeichen, teilweise unter Hinzufügung kleiner Buchstaben, bezeichnet.

Merkmale, die nur in Bezug zu einem Ausführungsbeispiel beschrieben sind, können im Rahmen der Erfindung auch bei jedem anderen Ausführungsbeispiel der Erfindung vorgesehen werden. Derartig geänderte Ausführungsbeispiele sind - auch wenn sie in den Zeichnungen nicht dargestellt sind - von der Erfindung mit umfasst.

Alle offenbarten Merkmale sind für sich erfindungswesentlich. In die Offenbarung der Anmeldung wird hiermit auch der Offenbarungsinhalt der zugehörigen Prioritätsunterlagen (Abschrift der Voranmeldung) sowie der zitierten Druckschriften und der beschriebenen Vorrichtungen des Standes der Technik vollinhaltlich mit einbezogen, auch zu dem Zweck, einzelne oder mehrere Merkmale dieser Unterlagen in einen oder in mehrere Ansprüche der vorliegenden Anmeldung mit aufzunehmen.

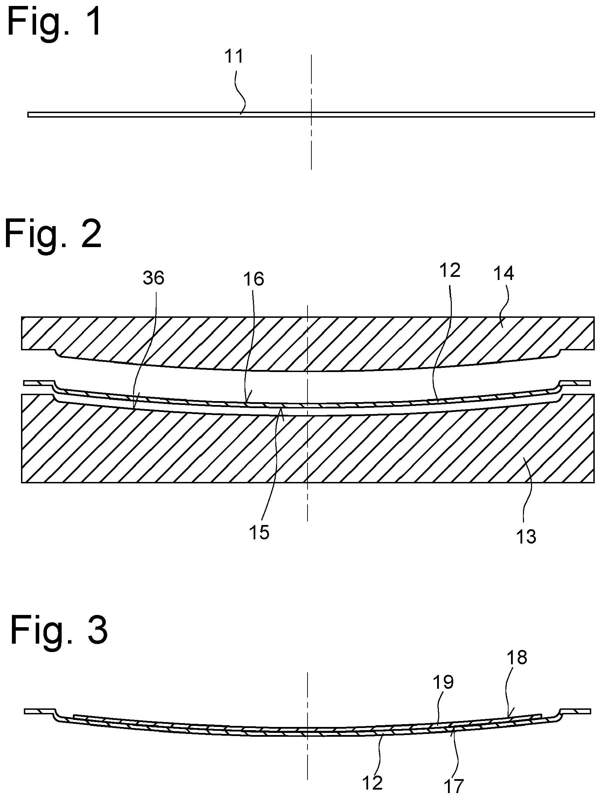

Zunächst soll gemäß einem ersten Aspekt der Erfindung die Schar der Ausführungsbeispiele gemäß den Figuren 1 bis 13 erläutert werden. Es handelt sich hierbei um Ausführungsbeispiele, die unter Durchführung der Schritte e) und f) des Anspruches 1 gefertigt werden, und entsprechende Verfahren voraussetzen.

Das erfindungsgemäße Bauelement ist in den Zeichnungen insgesamt mit dem Bezugszeichen 10 bezeichnet.

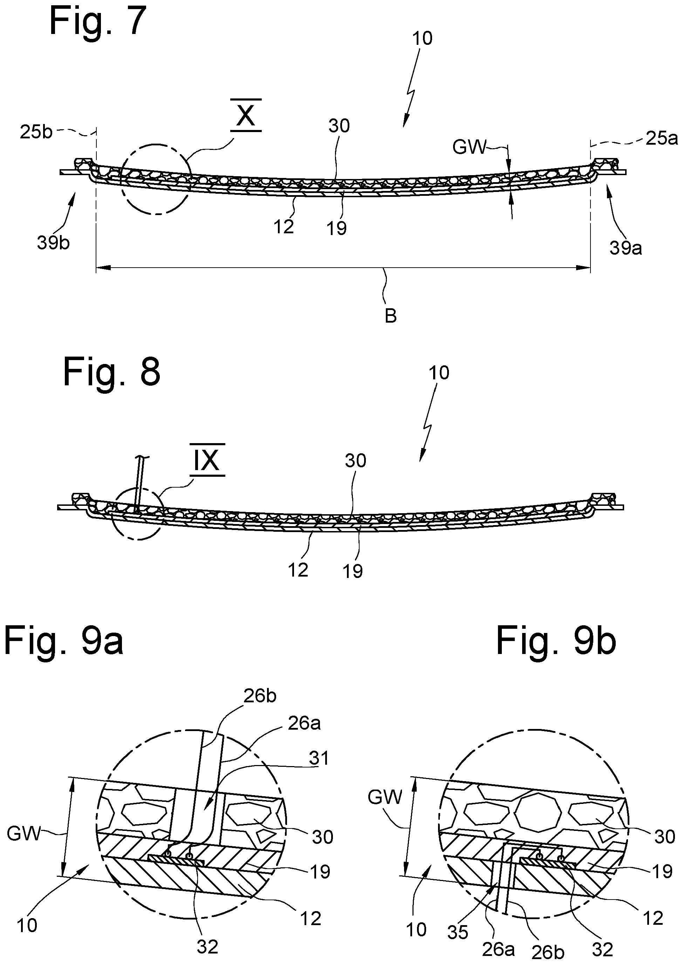

Ein solches Bauelement ist im fertig hergestellten Zustand in Fig. 7 in Alleindarstellung dargestellt. Das Bauelement besteht aus unterschiedlichen Schichten 12, 19, 30, die später im Einzelnen erläutert werden. Zunächst sei darauf hingewiesen, dass das Bauelement 10 insgesamt flächenhaft ausgebildet ist und daher eine Gesamtwandstärke GW aufweist, die deutlich kleiner ist, als die Breite B des Bauelementes 10. Die Länge L des Bauelementes in einer Richtung quer zur Papierebene der Fig. 7 liegt in der Größenordnung der Breite B und ist damit ebenfalls erheblich größer als die Gesamtwandstärke GW.

Die Breite B und die Länge L können beispielsweise das 5- bis 1000-fache der Gesamtwandstärke GW betragen.

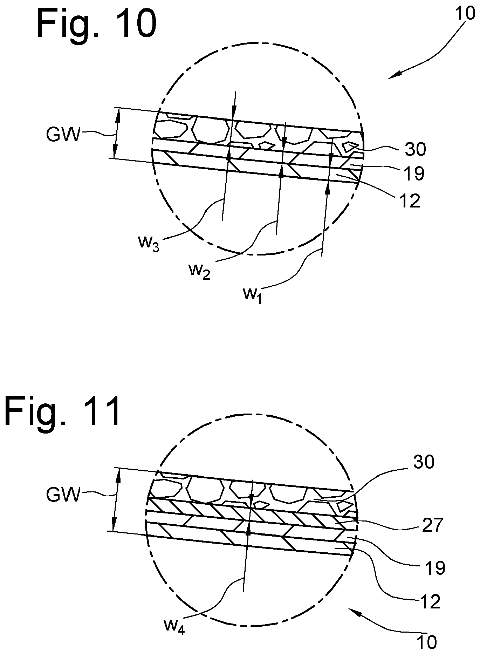

Zur Herstellung des Bauelementes 10 gemäß Fig. 7 wird wie folgt vorgegangen:
Ausgehend von Fig. 1 wird zunächst eine tiefziehbare Folie 11 bereitgestellt. Diese weist eine Wandstärke W₁ (Fig. 10) auf, die beispielsweise zwischen 0,1 mm und 10 mm, vorzugsweise zwischen 0,5 mm und 3 mm beträgt. Die tiefziehbare Folie 11 besteht aus einem transparenten, also durchsichtigem Material, welches zumindest bestimmte Spektralbereiche des von der Sonne emittierten elektromagnetischen Strahlungsspektrums hindurch lässt. Als Material für die tiefziehbare Folie 11 kommt insbesondere Polycarbonat oder PMMA in Betracht.

Die tiefziehbare Folie 11 wird in ein Werkzeug eingelegt, welches ein Unterwerkzeug 13 und ein Oberwerkzeug 14 gemäß Fig. 2 umfasst. In Folge eines Schließvorganges des Werkzeugs kann die Folie 11 tiefgezogen werden und ihre in Fig. 2 dargestellte tiefgezogene Form 12 erreichen. Hierbei wird in Folge des Tiefziehvorganges die Folie verformt.

Von der Erfindung sind auch Tiefzieh-Schritte umfasst, bei denen in Folge eines Blas-Umformvorganges die Formgebung der tiefziehbaren Folie 11, ausgehend von einem planen flachliegenden Zustand, in die gewünschte Raumform erreicht wird. Hierzu kann das Werkzeug 13 temperiert sein, und es können beispielsweise Ansaugvorrichtungen vorhanden sein, um die Außenseite 15 der tiefziehbaren Folie 11 an die Innenseite 36 des Unterwerkzeugs 13 heranzuziehen. Bei derartigen Tiefziehvorgängen, die nach Art von Blasvorgängen stattfinden, ist ein Oberwerkzeug 14 nicht oder nicht zwingend erforderlich.

Fig. 2 zeigt einen halbgeöffneten Zustand des Werkzeuges, in dem das Oberwerkzeug 14 von dem Unterwerkzeug 13 beabstandet ist.

Die tiefgezogene Folie 12 ist - lediglich zu Illustrationszwecken - leicht beabstandet von dem Unterwerkzeug 13 dargestellt.

Nachfolgend kann gemäß einer Variante der Erfindung die tiefgezogene Folie 12 aus dem Werkzeug entnommen werden. Bei einer anderen Variante der Erfindung kann die tiefgezogene Folie 12 in dem Unterwerkzeug 13 verbleiben.

In einem weiteren Schritt wird nun an der Innenseite 16 der tiefgezogenen Folie 12 eine Struktur 19 angebracht, die Solarzellen 32 umfasst.

Die Struktur 19 kann ausschließlich aus Solarzellen 32 bestehen, oder Solarzellen 32 umfassen. Die Struktur 19 kann als Handhabungseinheit bereitgestellt sein. Sie kann insbesondere als flächenhaftes, gegebenenfalls auch an die Kontur der Innenseite 16 der tiefgezogenen Folie 12 anschmiegbares Element ausgebildet sein. Die Struktur 19 kann als aufklebbare Folie bereitgestellt werden. Die Struktur 19 kann bei einer Variante der Erfindung ein Verbundbauteil sein, welches neben den eigentlichen zur Stromerzeugung dienenden Solarzellen 32 auch Kunststoffanteile, Trägermaterialen, Substrate oder dergleichen umfasst, auf denen die Solarzellen 32 aufgebracht sind.

Im einfachsten Fall erfolgt eine Anbringung der Struktur 19 auf der Innenseite 16 der tiefgezogenen Folie 12 mittels eines Klebevorgangs. Hierzu kann die Außenseite 17 der Struktur 19 mit einer Klebeschicht versehen sein und/oder die Innenseite 16 der tiefgezogenen Folie 12 kann mit einer entsprechenden Klebeschicht versehen sein. Alternativ ist es auch möglich, dass die Struktur 19 auf ihrer Außenseite 18 von einem Trägermaterial überfangen oder überdeckt wird, welches die Struktur 19 außenseitig übergreift und auf die Innenseite 16 der Folie 12 aufgeklebt wird.

Von der Erfindung ist auch umfasst, wenn die Anbringung der Struktur 19 auf der tiefgezogenen Folie 12 nur zum Zwecke der Erreichung einer Art Vormontagezustand erfolgt, so dass nur für einen kurzen Zeitraum eine Positionswahrung erreicht wird. Bei einer Variante der Erfindung genügt es daher insoweit, dass die Struktur 19 nur kurzzeitig auf die Innenseite 16 der tiefgezogenen Folie aufgelegt wird.

Gemäß einem weiteren Verfahrensschritt, der anhand der Fig. 4 erläutert wird, wird auf die tiefgezogene Folie 12 mit daran angebrachter Struktur 19 eine flüssige Polyurethan-Vergussmasse 24 aufgebracht. Dies erfolgt erfindungsgemäß in einem Werkzeug 34, welches weiter vorteilhafterweise ein Unterwerkzeug 13 und ein Oberwerkzeug 14 umfasst.

Das Werkzeug 34 kann bei einer Variante der Erfindung dasselbe Werkzeug sein, das in Fig. 2 dargestellt ist, in dem bereits der Tiefziehvorgang durchgeführt worden ist. In diesem Falle ist es bei einer Variante der Erfindung nicht erforderlich, dass die tiefgezogene Folie 12 überhaupt aus dem Unterwerkzeug 13 entfernt wird. Auch die Anbringung der Struktur 19 kann unmittelbar, bei in dem Unterwerkzeug 13 verbleibender tiefgezogener Folie 12, erfolgen.

Bei einer Variante der Erfindung ist die tiefgezogene Folie 12 nach dem Tiefziehvorgang aus dem in Fig. 2 dargestellten Werkzeug entfernt und in das Werkzeug 34 in Fig. 4 verbracht worden und in den Innenraum 33 des dort dargestellten Werkzeuges 34 eingebracht worden. Eine Anbringung der Struktur 19 an der tiefgezogenen Folie 12 kann bei diesem Ausführungsbeispiel im Innenraum 33 des Werkzeuges 34 erfolgen, oder bei einer weiteren Variante der Erfindung, auch außerhalb des Werkzeuges 34. Bei der zuletzt geschilderten Variante kann eine Verbringung der tiefgezogenen Folie 12, mit daran angebrachter Struktur 19, von einem externen Ort, an dem die Struktur 19 an die Folie 12 angebracht wurde, zu dem Werkzeug 34 der Fig. 4 erfolgen.

Fig. 4 zeigt den Zustand, in dem die tiefgezogene Folie 12 mit daran angebrachter Struktur 19 in das Unterwerkzeug 13 eingelegt ist.

Gemäß der Erfindung ist ein Mischkopf 20 vorgesehen, dem über eine Zuleitung 21 flüssige Polyurethan-Vergussmasse, gegebenenfalls auch unter Zuführung von Verstärkungsfasern, zugeführt wird.

Eine Mischung der Polyol-Komponente und der IsocyanatKomponente erfolgt vorzugsweise erst im Mischkopf.

Zur Vermeidung von Wiederholungen wird auf die eingangs genannten zahlreichen Patentanmeldungen der Anmelderin verwiesen, die diesen Mischvorgang und die chemischen Prozesse im Detail erklären.

Der Mischkopf 20 ist, angedeutet schematisch durch den Bewegungsrichtungspfeil 23, entlang der Innenseite 16 der tiefgezogenen Folie 12 bzw. entlang der Innenseite 18 der Struktur 19 verfahrbar. Dem Mischkopf 20 ist eine Austragungsvorrichtung 22 zugeordnet, mit der flüssige Polyurethan-Vergussmasse 24 abgegeben werden kann. Fig. 4 zeigt einen Zustand, in dem nur ein Teilabschnitt der Innenseite 16, 18 der tiefgezogenen Folie 12 und Struktur 19 mit flüssiger Polyurethan-Vergussmasse belegt oder benetzt ist.

Der Einbringungsvorgang der flüssigen Polyurethan-Vergussmasse 24 ist abgeschlossen, wenn ein im Wesentlichen vollflächiger Auftrag erreicht ist. Von der Erfindung ist auch umfasst, wenn, in Abhängigkeit von der Einstellung der Viskosität der Polyurethan-Vergussmasse 24, auch ein selbstständiges, zumindest teilweises Fließen der flüssigen Polyurethan-Vergussmasse 24 entlang der Innenseite 16, 18 im Zuge des Einbringungsvorganges erfolgt.

Gemäß der Erfindung wird nachfolgend das Werkzeug 34 geschlossen und das Oberwerkzeug 14 hierzu auf das Unterwerkzeug 13 hin zubewegt, so dass eine geschlossene Kavität entsteht.

Unter Einwirkung von Druck und Temperatur schäumt die Polyurethan-Vergussmasse, innerhalb einer vorgegebenen Reaktionszeit, auf und bildet eine ausgehärtete Versteifungsschicht 30 aus. Das Volumen der ausgehärteten Versteifungsschicht 30 ist erheblich größer als das Volumen der eingebrachten Polyurethan-Vergussmasse 24.

Vorzugsweise erfolgen das Aufschäumen und das Aushärtenlassen bei geschlossenem Werkzeug.

Fig. 5 zeigt einen Zustand, in dem die Versteifungsschicht 30 fertig ausgebildet ist, die Polyurethan-Vergussmasse 24 mithin ausgehärtet ist.

Die Detaildarstellung gemäß Fig. 6 gibt im Randbereich - lediglich schematisch und beispielhaft - etwa die Größenverhältnisse der einzelnen Schichten wieder.

Die Struktur 19 kann sich mit ihrem Randbereich 37 bis nahe an den Randbereich 38 der tiefgezogenen Folie 12 heran erstrecken.

Andererseits sind von der Erfindung auch Ausführungsformen umfasst, bei denen zwischen dem Randbereich 38 der tiefgezogenen Folie 12 und dem Randbereich 37 der Solarzellen 32 enthaltenden Struktur 19 große Abstände liegen.

Ausweislich Fig. 7 kann das so gebildete Bauelement 10 nun aus der Werkzeugform entnommen werden. Fig. 7 verdeutlicht Abtrennkanten 25a, 25b, entlang derer eine Trennung von Überstandsbereichen 39a, 39b erfolgen kann. Die Überstandsbereiche 39a, 39b sind dem Herstellungsverfahren geschuldet und berücksichtigen beispielsweise, dass beim Tiefziehen Überstände zu Zwecken der Werkzeugabdichtung vorgesehen sein müssen.

Der Schichtaufbau des fertiggestellten Bauelementes 10 gemäß Fig. 7 ist in der Teilkreisdarstellung der Fig. 10 zu sehen. Deutlich erkennbar sind die unterschiedlichen Wandstärken W₁ der tiefgezogenen Folie 12, W₂ der Struktur 19 und W₃ der Versteifungsschicht 30.

Die Versteifungsschicht 30 versteift das Bauelement insgesamt so, dass dieses trotz der großen Breite B und der großen nicht dargestellten Länge L und der nur sehr geringen Gesamtwandstärke GW insgesamt biegesteif ausgebildet ist und auf herkömmliche Weise, wie ein Fahrzeugteil, eingesetzt werden kann .

Gemäß einer Variante der Erfindung, die in Fig. 11 dargestellt ist, ist zwischen der Struktur 19 und der Versteifungsschicht 30 eine Schicht vorgesehen, die als Barriereschicht 27 bezeichnet wird. Ein solches Barrierecoat wird von einer Barriereschicht-Vergussmasse bereitgestellt, die auf die Innenseite 16 der tiefgezogenen Folie 12 bzw. auf die Innenseite 18 der Struktur 19 aufgebracht wird, bevor die Polyurethan-Vergussmasse 24 eingebracht wird. Vorzugsweise ist vorgesehen, dass ein Aushärtenlassen der Barriereschicht-Vergussmasse 27 erfolgt, bevor die Polyurethan-Vergussmasse 24 eingebracht wird.

Die Barriereschicht 27 kann vorteilhafterweise dazu dienen, einen Blick eines Betrachters von der Außenseite des fertig hergestellten Bauelementes 10 her auf die Versteifungsschicht 30 zu vermeiden. Daher können sich keinerlei Strukturen der Versteifungsschicht 30 auf der Oberfläche abzeichnen.

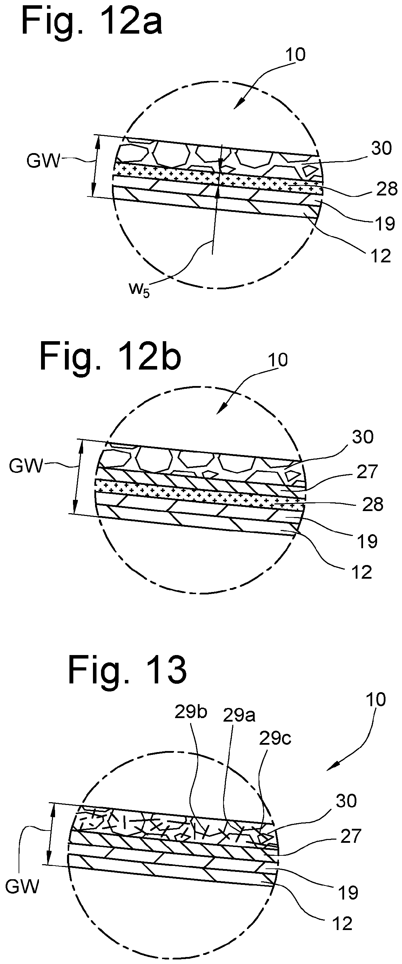

Insbesondere wenn, wie in dem Ausführungsbeispiel der Fig. 13 dargestellt, in der flüssigen Polyurethan-Vergussmasse 24 Verstärkungsfasern 29a, 29b, 29c vorgesehen sind, z. B. Kurzfasern oder Langfasern, können sich diese Faserstrukturen durch das Vorhandensein der Barriereschicht 27 auf der Oberfläche nicht abzeichnen.

Gemäß einer weiteren vorteilhaften Ausgestaltung der Erfindung ist ausweislich Fig. 12a vorgesehen, dass zwischen der Struktur 19 mit den Solarzellen 32 und der Versteifungsschicht 30 eine in-mould-paint-Schicht 28 angeordnet ist. Es handelt sich hierbei um einen Farbauftrag, also eine Art Lack, der auf der Innenseite 16 der tiefgezogenen Folie 12 bzw. auf der Innenseite 18 der Struktur 19 angebracht wird. Dieser Lack bildet eine in-mould-paint-Schicht 28 aus. Vorteilhafterweise erfolgt ein Auftrag auf die Innenseite 16 der tiefgezogenen Folie 12 und auf die Innenseite 18 der Struktur 19, bevor die flüssige Polyurethan-Vergussmasse 34 aufgetragen wird. Außerdem ist vorteilhaft vorgesehen, dass die in-mould-paint-Schicht 28 zunächst aushärtet, bevor die Polyurethan-Vergussmasse 24 aufgebracht wird.

Bei einem weiteren, nicht dargestellten Ausführungsbeispiel umfasst der Schichtaufbau des Bauelementes 10 eine in-mould-paint-Schicht 28 und zusätzlich eine Barriereschicht 27. Ein solches Ausführungsbeispiel ist in Fig. 12b dargestellt.

Gemäß einem weiteren Ausführungsbeispiel der Erfindung wird nun ausweislich der Fig. 8, 9a und 9b erläutert, dass die Struktur 19 mit Solarzellen 32 auch über elektrische Anschlussleitungen 26a, 26b verfügen kann:
Fig. 9a macht schematisch deutlich, dass die Struktur 19 Solarzellen 32 aufweist. Dargestellt ist der Übersichtlichkeit halber nur eine einzige Solarzelle 32 in Form eines flächenhaften Moduls. Dieses ist lediglich schematisch zu verstehen: Die Struktur 19 kann insgesamt aus Solarzellen 32 bestehen, oder eine Vielzahl derartiger Solarzellen 32 umfassen. Die Struktur 19 kann aber auch ein Trägermaterial oder eine Matrix für die Solarzellen 32 aufweisen.

Dem Fachmann ist deutlich, dass die von den Solarzellen 32 erhaltene elektromagnetische Strahlung nach Umwandlung in elektrische Energie über Zuleitungen 26a, 26b abgeführt werden muss. Hierzu sind Anschlussleitungen 26a, 26b vorgesehen, die auf an sich bekannte Weise mit der Solarzelle 32 oder den Solarzellen 32 verbunden werden können. Um die Anschlüsse von dem Innenraum des Fahrzeuges oder von dem Motorraum oder Kofferraum her zu ermöglichen, ist vorteilhafterweise vorgesehen, dass in der Versteifungsschicht 30 ein Kanal 31 vorgesehen ist, der einen Durchtritt zumindest von Abschnitten der elektrischen Leitungen 26a, 26b ermöglicht. Hierdurch besteht die Möglichkeit, die Anschlüsse innenseitig des Bauelementes 10, z. B. im Bereich des Innenraums des Fahrzeugs oder im Bereich des Motorraums des Fahrzeugs oder des Kofferraums des Fahrzeugs vorzusehen.

Die Anordnung des Kanals 31 in der Versteifungsschicht 30 kann nach erfolgter Herstellung der Versteifungsschicht 30 erfolgen. Alternativ können auch entsprechende Inserts bei der Herstellung der Versteifungsschicht vorgesehen sein.

Alternativ kann vorgesehen sein, dass die elektrischen Zuleitungen nach der Anbringung der Struktur 19 auf der tiefgezogenen Folie 12 bereits mit angebracht werden, und bei der Einbringung der flüssigen Polyurethan-Vergussmasse 24 und der Aushärtung zu einer Versteifungsschicht 30 mit umschäumt werden.

Auch kann der Kanal 31 als eine Art Aufnahmefach zur Unterbringung eines Anschlussbauteils, wie beispielsweise eines Steckers, einer Buchse oder eines Verbindungselementes, z. B. nach Art eines Steckverbinders, ausgebildet sein.

Ausweislich des Ausführungsbeispiels der Fig. 9b ist vorgesehen, dass ein Kanal 35 für den Durchtritt von Abschnitten der elektrischen Zuleitungen 26a, 26b in der Folie 12 angeordnet ist. Hier werden die Zuleitungen 26a, 26b also zum Außenraum hin geführt.

Diese Variante ist z. B. vorteilhaft, wenn auf der Außenseite des Bauelementes 10 Anbauteile angeordnet sind, um in den Anbauteilen von der Struktur 19 erhaltene elektrische Energie zu speichern oder von den Anbauteilen weiterzuleiten oder um an den Anbauteilen angeordnete elektrische Verbraucher mit Strom zu versorgen.

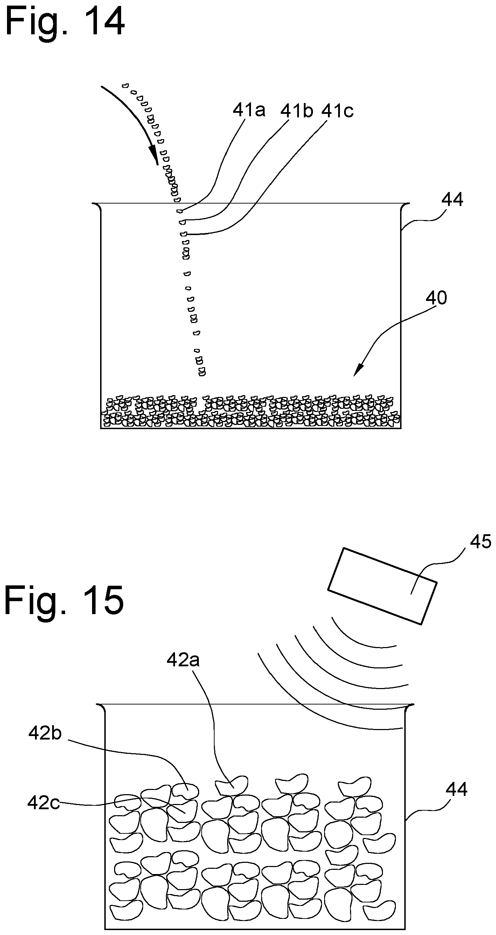

Im Folgenden soll anhand der Ausführungsbeispiele der Figuren 14 bis 18 eine Schar zweiter Varianten der Erfindung erläutert werden:
Diese Varianten greifen zurück auf Verfahren nach Anspruch 1, die die Merkmalsgruppen j) und k) umfassen.

Zunächst wird auf Fig. 14 verwiesen, die schematisch dargestellt ein Behältnis 44 zeigt, in dem eine unaufgeschäumte granulare Partikelschaummasse 40 angeordnet ist, und gerade in das Behältnis 44 eingefüllt wird. Einzelne Partikel sind teilweise mit Bezugszeichen 41a, 41b, 41c beispielhaft bezeichnet. Die unaufgeschäumten Granularpartikel 41a, 41b, 41c können beispielsweise aus einem aufschäumbaren Kunststoff aus EPS, EPE, oder PEEK bestehen. Die unaufgeschäumten Granularpartikel 41a, 41b, 41c weisen ein sehr kleines Volumen auf, beispielweise Abmessungen in der Größenordnung von 0,1 bis 3 mm Außendurchmesser, und können eine beliebige Geometrie, beispielsweise eine Kugelform, aufweisen.

Fig. 15 stellt exemplarisch eine Aufschäumvorrichtung 45, insbesondere nach Art eines Infrarot-Ofens dar. Unter Einfluss der von der Aufschäumvorrichtung auf die Partikel 41a, 41b, 41c aufgebrachten Strahlung oder Temperatur können die unaufgeschäumten Granularpartikel 41a, 41b, 41c zu aufgeschäumten Granularpartikeln 42a, 42b, 42c unter erheblicher Volumenvergrößerung anwachsen. Fig. 15 zeigt die aufgeschäumten Granularpartikel 42a, 42b, 42c mit unregelmäßiger Kontur. Von der Erfindung sind insbesondere aufgeschäumte Granularpartikel umfasst, die eine Kugelform aufweisen.

Die Summe der aufgeschäumten Granularpartikel 42a, 42b, 42c macht die für das erfindungsgemäße Verfahren als Ausgangsmaterial verwendete granulare Partikelschaummasse 43 aus.

Ausweislich Fig. 16 wird - analog zu der Beschreibung des Ausführungsbeispiels der Fig. 4, auf die zur Vermeidung von Wiederholungen verwiesen wird - in das Unterwerkzeug 13 die tiefgezogene Folie 12 mit darauf angebrachter Struktur 19 eingelegt. Bei geöffnetem Werkzeug wird die granulare Partikelschaummasse 43 in den Innenraum 33 des Werkzeugs 34 eingebracht, und dort verteilt.

Nachfolgend wird das Werkzeug 34 geschlossen, wobei das Oberwerkzeug 14 auf das Unterwerkzeug 13 zubewegt wird. Bei geschlossenem Werkzeug, welches durch eine Heizung 48 temperiert ist, können die aufgeschäumten Granularpartikel 42, 42b, 42c miteinander verbacken oder versintern. Das Verbacken der granularen Partikelschaummasse 43 erfolgt unter Temperatur- und/oder Druckeinfluss. Das Werkzeug 34 kann insbesondere einer Temperaturwechselbeanspruchung unterliegen:
Während eine höhere Temperatur, insbesondere oberhalb des Schmelzpunktes der granularen Partikelschaummasse 43 vorgesehen ist, um den Prozess des Verbackens oder Versinterns der aufgeschäumten Granularpartikel 42a, 42b, 42c durchzuführen, wird das Werkzeug 34 nach Ablauf einer vorgeschriebenen Zykluszeit entweder nicht weiter geheizt oder gekühlt, ggf. auch durch eine gesonderte Kühleinrichtung, um eine Temperatur unterhalb des Schmelzpunktes der granularen Partikelschaummasse 43 zu erreichen.

Die auf diese Weise gebildete ausgehärtete Versteifungsschicht 30 wird insoweit von einer ausgehärteten Partikelschaummasse 46 bereitgestellt.

Im Zuge des Verbackens der aufgeschäumten Partikel 42a, 42b, 42c miteinander geht die Partikelschaummasse auch eine feste Verbindung zu der tiefgezogenen Folie 12 und zu der die Solarzellen beinhaltenden Struktur 19 ein.

Nach einem Öffnen des Werkzeugs 34 gemäß Fig. 17 kann das so gefertigte Bauteil 10 gemäß Fig. 18 aus der Form entnommen werden.

Zur Vermeidung von Wiederholungen wird auf die obigen Ausführungen zu den vorherigen Ausführungsbeispielen der Fig. 1 bis 13 verwiesen, die analog auch zu den Ausführungsbeispielen der Fig. 16 bis 18 gelten.

Insbesondere wird angemerkt, dass auch eine Barrierecoatschicht 27 und/oder eine Mouldpaintschicht 28, wie dies in den Zeichnungen des Ausführungsbeispiels gemäß den Figuren 14 bis 18 nicht dargestellt ist, bei diesen Ausführungsbeispielen vorgesehen sein können.

Von der Erfindung ist weiter umfasst, wenn die aufgeschäumten Granularpartikel 42a, 42b, 42c, die die granulare Partikelschaummasse 43 bilden, im Zuge des Schrittes des Verbackens in dem Werkzeug 34 aus einem vorgeschäumten Zustand in einen endgeschäumten Zustand überführt werden, mithin der Schritt des Verbackens eine Volumenvergrößerung der aufgeschäumten Granulatpartikel 42a, 42b, 42c von einem vorgeschäumten Zustand hin zu einem endaufgeschäumten Zustand mit sich bringt.

Von der Erfindung ist auch umfasst, wenn aufschäumbare Kunststoffe zur Bereitstellung der granularen Partikelschaummasse verwendet werden, die in einem endaufgeschäumten Zustand in das Werkzeug 34 eingebracht werden, und mithin der Schritt des Verbackens ohne Volumenänderung der Granularpartikel 42a, 42b, 42c erfolgt.

Von der Erfindung ist schließlich auch umfasst, wenn im Zuge des Verbackens infolge der Druckeinwirkung und/oder der Temperatureinwirkung in dem geschlossenen Werkzeug 34 eine Volumenreduzierung der aufgeschäumten Granularpartikel 42a, 42b, 42c erfolgt.

Unter Bezugnahme auf Fig. 16 sei angemerkt, dass ein Einbringen der granularen Partikelschaummasse 43 in das Werkzeug 34 entlang der Einführrichtung 47 manuell oder maschinell erfolgen kann, wobei eine Verteilung der aufgeschäumten Granularpartikel 42a, 42b, 42c selbständig oder manuell oder maschinell und/oder automatisch entlang des Innenraums 33 des Werkzeugs erfolgen kann.

Von der Erfindung ist weiter eine Ausführungsform umfasst, die vorsieht, dass das Werkzeug 34 überladen wird, also eine Menge an granularer Partikelschaummasse in den Innenraum 33 des Werkzeugs 34 eingefüllt wird, deren Volumen das Volumen des Innenraums 33 übersteigt. Bei einer Werkzeugschließung im Zuge des Schrittes des Verbackens der Granularpartikel 42a, 42b, 42c kann eine Reduzierung des Volumens der Granularpartikel 42a, 42b, 42c erfolgen.

Bezüglich des Ausführungsbeispiels der Figuren 14 bis 18 sei auch noch angemerkt, dass die Merkmale der Ausführungsbeispiele der Figuren 1 bis 13, beispielsweise die anhand der Figuren 8 bis 9b beschriebene Anbindung der Solarzellen enthaltenen Strukturen 19 mit elektrischen Leitungen, gleichermaßen vorgesehen sein können.

## Patentansprüche

1. Verfahren zur Herstellung eines flächenhaften Bauelementes (10) für Außenanwendungen, umfassend die folgenden Schritte:
a) Bereitstellen einer tiefziehbaren Folie (10) aus einem transparenten Kunststoff,
b) Tiefziehen der Folie (11) in einem Werkzeug (34),
c) Anbringen einer Struktur (19), die Solarzellen (32) umfasst, an einer Innenseite (16) der tiefgezogenen Folie (12),
d) Anordnen der tiefgezogen Folie (12) mit angebrachter Struktur (19) in dem Innenraum (33) eines insbesondere wenigstens zwei Werkzeughälften (13, 14) umfassenden Werkzeuges (34),
e) Einbringen einer flüssigen Polyurethan-Vergussmasse (24) in den Innenraum (33) des Werkzeuges (34) und Verteilen der Polyurethan-Vergussmasse (24) entlang einer Innenseite (18) der Struktur (19) und/oder entlang der Innenseite (16) der Folie (12),
f) Aushärtenlassen der Polyurethan-Vergussmasse, insbesondere bei geschlossenem Werkzeug, unter Ausbildung einer Versteifungsschicht (30),
oder umfassend anstelle der Schritte e) und f) die folgenden Schritte j) und k):
j) Einbringen einer granularen Partikelschaummasse in den Innenraum (33) des Werkzeuges (34) und Verteilen der granularen Partikelschaummasse entlang einer Innenseite (18) der Struktur (19) und/oder entlang der Innenseite (16) der Folie (12),
k) Verbacken der granularen Partikel zu einer Partikelschaummasse und Aushärtenlassen der Partikelschaummasse, insbesondere bei geschlossenem Werkzeug, unter Ausbildung einer Versteifungsschicht (30),
g) Entnehmen des auf diese Weise gefertigten Bauelementes (10) aus dem Werkzeug.

2. Verfahren nach Anspruch 1, **dadurch gekennzeichnet, dass** die Folie (11) aus Polycarbonat oder PMMA besteht.

3. Verfahren nach einem der Ansprüche 1 oder 2 umfassend die Schritte e) und f), **dadurch gekennzeichnet, dass** die Polyurethan-Vergussmasse (24) Verstärkungsfasern (29a, 29b, 29c), insbesondere Kurzfasern oder Langfasern, umfasst.

4. Verfahren nach einem der vorangegangenen Ansprüche, **dadurch gekennzeichnet, dass** die Struktur (19) auf die Innenseite (16) der tiefgezogenen Folie (12) aufklebbar ist.

5. Verfahren nach einem der vorangegangenen Ansprüche, **dadurch gekennzeichnet, dass** vor Schritt e) oder vor Schritt j) der folgende Schritt durchgeführt wird:
h) Einbringen einer flüssigen Barriereschicht-Vergussmasse (27), insbesondere aus Polyurethan, in den Innenraum (33) des Werkzeuges (34) und Verteilen der Barriereschicht-Vergussmasse (27) entlang einer Innenseite (18) der Struktur (19) und/oder entlang der Innenseite (16) der Folie (12).

6. Verfahren nach einem der vorangegangenen Ansprüche, **dadurch gekennzeichnet, dass** vor Schritt e) oder vor Schritt j) der folgende Schritt durchgeführt wird:
i) Einbringen einer flüssigen in-mould-paint-Vergussmasse (28) in den Innenraum (33) des Werkzeuges (34) und Verteilen der in-mould-paint-Vergussmasse (28) entlang einer Innenseite (18) der Struktur (19) und/oder entlang der Innenseite (16) der Folie (12).

7. Verfahren nach Anspruch 5 und 6, **dadurch gekennzeichnet, dass** der Schritt i) nach dem Schritt h) durchgeführt wird.

8. Verfahren nach einem der vorangegangenen Ansprüche, **dadurch gekennzeichnet, dass** die Schritte b) und d) und e) oder die Schritte b) und k) und k) in demselben Werkzeug (34) durchgeführt werden.

9. Verfahren nach einem der Ansprüche 1 bis 7, **dadurch gekennzeichnet, dass** die Schritte b) und d) und e) oder die Schritte b) und d) und j) in unterschiedlichen Werkzeugen durchgeführt werden, und die tiefgezogene Folie (12) nach Durchführung des Schrittes b) zur Durchführung der Schritte d) und e) oder zur Durchführung der Schritte d) und j) zu einem zweiten Werkzeug (34) verbracht wird.

10. Verfahren nach einem der vorangegangenen Ansprüche, **dadurch gekennzeichnet, dass** an die Struktur (19) elektrische Leitungen (26a, 26b) angeschlossen sind.

11. Verfahren nach Anspruch 10, **dadurch gekennzeichnet, dass** zumindest ein Abschnitt der Leitungen (26a, 26b) durch die Versteifungsschicht (30) hindurch verläuft.

12. Verfahren nach Anspruch 10 oder 11, **dadurch gekennzeichnet, dass** die Versteifungsschicht (30) einen Durchtrittskanal (35) für die elektrischen Leitungen (26a, 26b) aufweist.

13. Verfahren nach einem der vorangegangenen Ansprüche, **dadurch gekennzeichnet, dass** das Bauelement (10) als ein Exterieur-Bauelement für ein Fahrzeug, wie PKW, Nutzfahrzeug, Caravan, Landmaschine od. dgl., ausgebildet ist, und ein Dachelement, ein Seitenwandelement, eine Motorhaube, einen Kofferraumdeckel, einen Kotflügel oder ein Verkleidungsteil für dieses Fahrzeug ausbildet.

14. Bauelement (10), insbesondere flächenhaft ausgebildetes Bauelement, insbesondere hergestellt nach einem der vorangegangenen Ansprüche, umfassend eine tiefgezogene Folie (12) aus transparentem Kunststoff, auf dessen Innenseite (16) eine Struktur (19) angeordnet ist, die Solarzellen (32) umfasst, wobei die Folie (12) und/oder die Struktur (19) auf ihrer Innenseite (16, 18) mit einer Versteifungsschicht (30) aus Polyurethan oder aus einer Partikelschaummasse hinterschäumt ist.

15. Bauelement nach Anspruch 14, **dadurch gekennzeichnet dass** das Bauelement (10) als ein Exterieur-Bauelement für ein Fahrzeug, wie PKW, Nutzfahrzeug, Caravan, Landmaschine od. dgl., ausgebildet ist, und ein Dachelement, ein Seitenwandelement, eine Motorhaube, einen Kofferraumdeckel, einen Kotflügel oder ein Verkleidungsteil für dieses Fahrzeug ausbildet.
